# EUROPEAN PATENT APPLICATION

(11) **EP 1 085 797 A2**
(43) Date of publication of application: **21.03.2001**
(21) Application number: 00119137.8
(22) Date of filing: 04.09.2000
(51) Int. Cl.: H05K 9/00

(54) **Process and apparatus for producing an electromagnetically shielded housing**

(30) Priority: 13.09.1999 DE 19943657
(71) Applicant: Instrument Specialties, Delaware Water Gap, PA 18327-0650 (US)
(72) Inventor: Ait El Cadi, Mohamed, 75020 Paris (FR); Ducros, Jean-Alec, 77300 Fontainebleau (FR)
(74) Representative: Strobel, Wolfgang, Dipl.-Ing.

(57) **Abstract**

Process and apparatus for producing an electromagnetically shielded housing having at least two housing parts which are joined together at a joint by a flexible gasket. The gasket is applied as a strand of an electrically conductive pasty material by means of a path-controlled die. The pasty material is polymerizable at room temperature but for polymerization, the material of the strand is subjected to heat exposure above room temperature, which is adjustably controlled in temperature, duration of exposure, point in time of exposure and location of the exposure.

## Description

### Background of the Invention

The invention relates to a process and an apparatus for producing an electromagnetically shielded housing.

Electromagnetically shielded housings are widely used for electronic equipment which emits electromagnetic radiation or may suffer from interference as a result of electromagnetic radiation penetrating from outside. To provide shielding against EMI (electromagnetic interference) and RFI (radio-frequency interference) and improve electromagnetic compatibility (EMC), the housings are produced from an electrically conducting material or material with an electrically conducting coating. To provide shielding also in the region of the joints at which the parts of the housing are joined together, it is known to use gaskets of an electrically conductive flexible material.

Such a material is known for example from US 4 011 360. This known material polymerizes under the effect of atmospheric humidity. The polymerization accordingly requires a long period of time and the dependence on atmospheric humidity has the result that the polymerization process is also subject to strong fluctuations. Since the temperature has no influence on the polymerization, it is carried out at room temperature.

It is also known in the case of such housings to produce the gasket more efficiently by the sealing material being extruded in a pasty state as a strand onto one of the parts of the housing directly in the region of the joint, where it polymerizes to form the gasket (so-called formed-in-place gasket method). DE 43 19 965 C2 discloses such a process in which a silicone polymer made conductive by incorporated metal particles is dispensed by means of a path-controlled die. This sealing material sets very quickly at room temperature. This property of the sealing material used has the consequence that the material also quickly sets in the feed lines and the die, with the result that the cleaning of these parts of the installation is difficult. Furthermore, the rapid setting of the sealing material leaves little freedom in process control.

### Summary of the Invention

The invention is based on the object of providing a process for producing an electromagnetically shielded housing with higher reliability and greater flexibility as well as an apparatus for carrying out this process.

According to the invention, a conductive plastics material which is extruded in a pasty state as a strand onto the region of the joint of the housing to be sealed is used for producing the electromagnetically shielding gasket. This material polymerizes in order to form the flexible conductive gasket. The polymerization process takes a very long time at room temperature and requires many hours. According to the invention, the polymerization is accelerated by exposure to heat. As a result, the polymerization process can be controlled in an extremely versatile manner and can be adapted flexibly to the respective requirements.

Time-related control is possible, it being possible on the one hand to choose freely the point in time at which the exposure to heat commences and on the other hand to choose freely the period of time for which it is exposed to heat. Furthermore, it is possible to influence and control the polymerization process by the choice of temperature. Finally, the exposure to heat can take place at different spatial locations of the dispensing and production process, providing a further independent possible way of influencing the production process.

### Brief Description of the Drawings

The invention is explained in more detail below on the basis of exemplary embodiments, reference being made to the attached drawings, in which:
- Figure 1: graphically shows the dependence on the duration of polymerization and temperature,
- Figure 2: graphically shows the dependence of the degree of polymerization on time for different temperatures,
- Figure 3: schematically shows an apparatus for carrying out the process and
- Figure 4: schematically shows a further apparatus for carrying out the process.

### Detailed Description of the Preferred Embodiments

For producing an electrically conducting gasket for a shielding housing, a paste of an electrically conductive plastics material is applied by means of a path-controlled die directly to a part of the housing in the region in which the joint of the housing to be sealed is located. The die is preferably moved over the housing part by means of a computer-controlled handling device when the plastics material is being discharged. Conversely, it is also possible to move the housing part beneath the fixed die in a correspondingly computer-controlled manner.

The rate of relative movement of the die and the housing part is determined by the viscosity of the pasty plastics material, by the amount and rate of emergence of the material from the die, the cross-sectional area of aperture of the die, the desired profile cross section of the gasket and the composition of the plastics material.

Preferably the material used is a sealing material comprising only one component, i.e. a one part system. A silicone material in which metal particles or other conductive particles have been mixed to produce the electrical conductivity is preferably used. The proportion of conductive particles is determined essentially by the required conductivity of the gasket. Instead of silicone material, acrylic resins or epoxy resins which have adequate elasticity in the polymerized state may also be used.

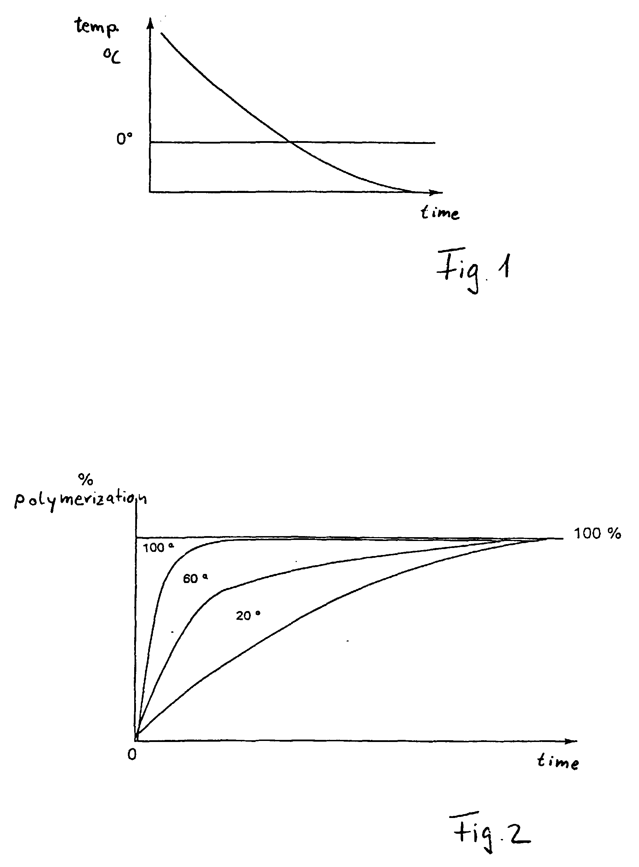

At room temperature, the plastics material polymerizes extremely slowly, with the result that the dispensed strand of plastics material is fully polymerized only after many hours. The polymerization process is accelerated by exposure to heat. The higher the temperature to which it is exposed, the more rapidly the polymerization process takes place. Figure 1 shows this relationship in a graphic representation, in which the polymerization time is plotted on the x-axis and the temperature is plotted on the y-axis. As Figure 1 shows, the duration of polymerization decreases progressively with increasing temperature of the exposure to heat.

In the case of a typical silicone plastic used according to the invention, with incorporated metal particles, a degree of polymerization of 99%, for example, is obtained at an ambient temperature of 20° C after approximately 16 hours, at an ambient temperature of 50° C after approximately 6 hours and at an ambient temperature of 100° C after approximately 3.5 hours.

It follows from this that the duration of the polymerization process can be influenced and chosen within very broad limits by the choice of the temperature of the heat exposure.

The upper limit of the temperature of the exposure to heat is determined not only by the plastics material used for the gasket but also by the material of the housing onto which the gasket is dispensed. If the housing consists of plastic, for example a conductive plastic or a plastic with a conductive coating, the exposure to heat should not exceed a temperature of 80° C. In the case of housing parts made of aluminum, the temperature of the exposure to heat should not exceed approximately 120° C.

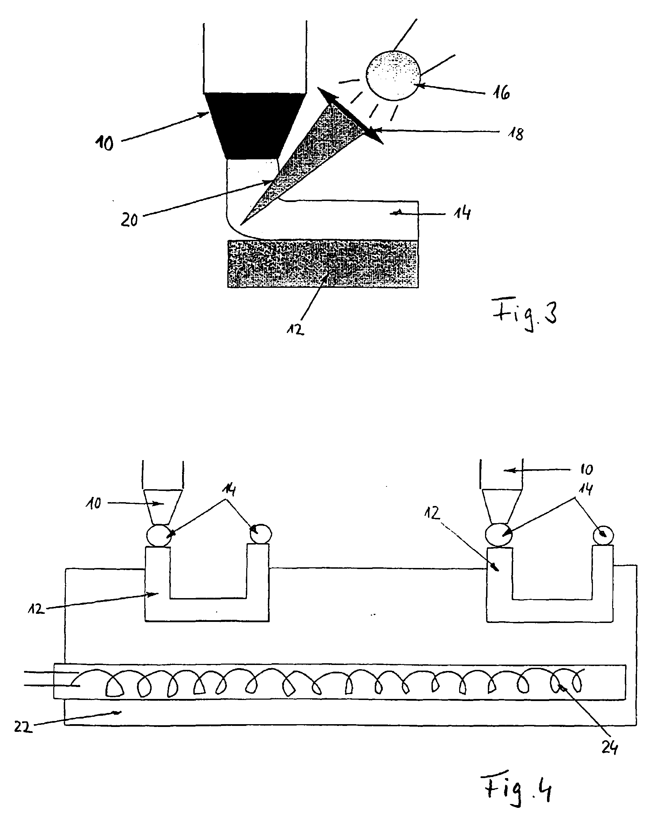

Apart from the temperature of the heat exposure, according to the invention the duration of the heat exposure can be used for controlling and optimizing the production process. The longer the exposure to heat, the further the polymerization process progresses. Consequently, in addition to the temperature of the heat to which it is exposed, the degree of polymerization of the sealing strand can be determined and influenced by the time for which it is exposed to the heat. This is graphically represented for example in Figure 2, in which the degree of polymerization in percent is plotted as a function of the duration of the exposure to heat for exposure temperatures of 20° C, 60° C and 100° C. It can be clearly seen that the polymerization progresses slowly at low temperatures, while full polymerization is reached much more quickly at high temperatures.

For the process according to the invention, the following are examples of typical values, obtained with a silicone paste polymerizing under exposure to heat at a temperature of 80° C. After exposure to this temperature for approximately five minutes, the surface of the dispensed strand of plastic has polymerized and set to such an extent that the housing part with the sealing strand applied can be removed from the installation with the path-controlled die. Then the next parts of the housing can be brought in to apply the strand of plastic, while the parts of the housing with the superficially polymerized strand of plastic are passed on for further thermal treatment. After approximately ten minutes, the plastics material has polymerized to approximately 50%. The housing part can then be transported and treated further without the risk of the extruded profile of the gasket being damaged. After exposure to heat for approximately one hour, the plastics material has fully polymerized and the process of producing the gasket has been completed.

A further parameter which can be varied and controlled according to the invention for optimizing the production process is the point in time at which the exposure to heat commences and is carried out. The exposure to heat will generally commence directly during or after the dispensing of the strand of plastics material. It is also possible, however, to carry out the exposure to heat at a later point in time or to change the exposure to heat to a later point in time. For example, after a first exposure to heat and superficial polymerization of the dispensed stand of plastic, a first quality control check may be carried out. Then poor parts can be segregated, so that they are no longer passed on for further polymerization, making it possible to save costs. Similarly, after a first partial polymerization, further processing operations can be carried out on the housing parts without any longer damaging the shape and surface of the already partially polymerized sealing strand.

It is particularly advantageous that the various parameters, such as the temperature of the heat exposure, duration of heat exposure and point in time of heat exposure, can be varied and combined in any way desired in order to optimize the production process in terms of time and quality. In particular, a number of heat exposure steps with different parameters can also be carried out successively.

For example, a production process may proceed in the following way:

Directly after dispensing the strand of plastics material, it is exposed to a temperature of 80° C for five minutes, with the result that a polymerization and setting of the surface of the strand is obtained. Then the parts of the housing with the strand of plastic are subjected to a first quality control check and parts with a defective sealing strand are segregated. The remaining, good parts are exposed to a temperature of 40° C for six hours, so that a degree of polymerization of approximately 50% is obtained. In this state, the sealing strand has already set to such an extent that damage is no longer to be feared. The housing parts with the sealing strand can then be passed on for further processing operations, for example identifications may be stamped into or printed onto the housing, screws for joining together the housing may be pressed in etc. Subsequently, the housing parts finished in this way are stored for a period of a further ten hours at room temperature, in order to bring about the full polymerization of the plastics material.

The apparatus for carrying out the process according to the invention may be designed in different ways. The way in which the exposure to heat is carried out depends on the one hand on the construction of the dispensing die and its path-control mechanism and on the other hand on the size and shape of the housing parts and the gasket to be applied. Furthermore, the structural design of the apparatus for providing the heat exposure depends on the stage in the production process in which the exposure to heat takes place, for which period of time the heat exposure takes place and how many housing parts are simultaneously subjected to heat exposure.

If the heat exposure is to take place directly when the strand of plastics material is discharged from the die, the heat can be directed straight at the strand of material emerging from the die, it possibly also being necessary to heat the outlet region of the die. Such a solution is schematically represented in Figure 3. Denoted there by 10 is a die, which is moved in a path-controlled manner over a housing part 12. A strand 14 of the pasty plastics material is dispensed from the die 10 and deposited on the housing part 12. An infrared radiation source 16 is arranged next to the die 10 and is moved with the latter. The infrared radiation of the radiation source 16 is focused by means of a lens 18 onto the strand 14 emerging from the die 10, in order to heat it, as schematically represented by 20.

Instead of infrared radiation, a jet of a heated-up fluid, for example a gas jet or air jet, may also be directed at the strand 14 emerging from the die 10. This form of heat exposure is suitable in particular for the first polymerization and setting of the surface of the dispensed strand of plastic 14.

Figure 4 shows a further configuration of an apparatus for carrying out the process. In the case of this apparatus, the housing parts 12 are fitted into a carrier mold 22, which is heated by a heating element 24, for example an electrical heating cartridge. The heated carrier mold 22 heats the housing part 12, from which in turn the heat is transferred to the strand of plastic 14 dispensed from the die 10. This type of heat exposure is suitable in particular for housing parts 12 of adequate thermal conductivity. If the housing parts 12 consist of an electrically conducting material, they also have adequate thermal conductivity to transfer the heat from the heated carrier mold 22 to the resting strand 14 of plastics material.

As Figure 4 shows, a carrier mold 22 may accommodate a number of housing parts 12, to which the plastics material is dispensed one after the other through a die 10 or simultaneously in parallel through a number of dies 10.

A further possibility is that of inductive heat exposure. Since the plastics material of the strand contains electrically conducting particles, thermal energy can be introduced into the strand by induction by means of the electromagnetic alternating field of a coil.

After the first superficial polymerization and setting of the dispensed strand of plastic, the housing parts are preferably removed from the installation with the path-controlled die or the path-controlled dies and are passed on for further polymerization. For the further heat exposure, the parts with the sealing strand may be transported through a heating tunnel, which facilitates exposure to higher temperatures and consequently shorter polymerization times. This is expedient in particular to obtain a polymerization of up to approximately 50%, in which state additional processing steps can be carried out.

For the subsequent full, final polymerization, the parts are brought into an oven or a temperature-controlled room, whereby a longer-lasting heat exposure with a great receiving capacity for a large number of housing parts is possible in a cost-effective way.

It is obvious that the process according to the invention is not restricted just to dispensing a single strand of the plastics material. It is also possible to apply a number of strands of plastics material one after the other lying next to or above one another, in order in particular to produce cross-sectional shapes of the sealing profile. In these cases, the strands of plastic dispensed one after the other are subjected to the heat exposure together. It is similarly possible to subject the individual strands to the heat exposure, or at least a first heat exposure, before the next strand is dispensed. This may make possible a more complicated cross-sectional construction of the gasket. It is also possible to subject the individual strands to heat exposures of different duration and different temperature. This may be of interest, for example, if strands of different materials are used for the construction of the gasket.

## Claims

1. Process for producing an electromagnetically shielded housing which has at least two housing parts which are joined together at a joint by a flexible gasket, the gasket being applied as a strand of an electrically conductive pasty material by means of a path-controlled die to at least one of the housing parts in the region of the joint and polymerizes there, wherein the material, which is room temperature polymerizable, is subjected to heat exposure above room temperature for the polymerization.

2. The process as claimed in claim 1, wherein the heat exposure takes place with an adjustably controlled temperature.

3. The process as claimed in claim 1, wherein the time duration of the heat exposure is adjustably controlled.

4. The process as claimed in claim 1, wherein the time at which the heat exposure begins is adjustably controlled.

5. The process as claimed in claim 2, wherein the temperature of the heat exposure can be controlled between room temperature and approximately 120° C.

6. The process as claimed in claim 5, wherein the upper limit of the temperature of the heat exposure for housing parts made of plastic lies around 80° C and for housing parts made of metal lies around 120° C.

7. The process as claimed in claim 3, wherein the duration of the heat exposure is adjustable between one minute and several hours.

8. The process as claimed in claim 1, wherein the heat exposure is exerted directly on the strand emerging from the die.

9. The process as claimed in claim 1, wherein the heat exposure is exerted from a heatable carrier for the housing parts via these housing parts onto the strand applied to the housing parts.

10. The process as claimed in claim 1, wherein the heat exposure is exerted by a heating tunnel, an oven or a temperature-controlled room.

11. The process as claimed in claim 1, wherein the heat exposure takes place in one or more steps with parameters which can be adjusted independently of one another.

12. The process as claimed in claim 1, wherein the conductive pasty material is a silicone plastic mixed with electrically conducting particles.

13. The process as claimed in claim 1, wherein the conductive pasty material is an acrylic or epoxy resin mixed with electrically conducting particles.

14. An apparatus for producing an electromagnetically shielded housing comprising: at least one die (10) which can be moved in a path-controlled manner for dispensing a strand (14) of an electrically conductive pasty material to a housing part (12) and having a device (16, 18; 22, 24) for applying heat to the strand (14).

15. The apparatus as claimed in claim 14, wherein the device for applying heat has an infrared radiation source (16), the radiation of which is focused onto the strand (14).

16. The apparatus as claimed in claim 14, wherein the device for applying heat has a source for a heated fluid, which is directed at the strand (14).

17. The apparatus as claimed in claim 14, wherein the device for applying heat has an induction heater.

18. The apparatus as claimed in claim 14, wherein the device for applying heat has a heatable carrier (22), which accommodates the housing parts (12).

19. The apparatus as claimed in claim 14, wherein a device for applying heat has a heating tunnel, an oven or a temperature-controlled room, in which the housing parts (12) with the applied strand (14) are accommodated.

20. The apparatus as claimed in claim 16, wherein the heated fluid is hot air.

21. An electromagnetically shielded housing, comprising at least two housing parts (12) which are joined together by a flexible, electrically conductive gasket, wherein the gasket is formed by a strand (14) of an electrically conductive pasty material which is polymerizable at room temperature and is applied directly to at least one of the housing parts (12) and is polymerized by heat exposure.
